(19) Europäisches Patentamt
European Patent Office
Office européen des brevets

(11) **EP 4 498 163 A1**

(12) **EUROPEAN PATENT APPLICATION**

(43) Date of publication:
**29.01.2025  Bulletin 2025/05**

(51) International Patent Classification (IPC):
*G03F 7/20* (2006.01)

(21) Application number: **23188234.1**

(52) Cooperative Patent Classification (CPC):
**G03F 7/706837**

(22) Date of filing: **27.07.2023**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventors:
• **THISSEN, Nick, Franciscus, Wilhelmus**
**Veldhoven (NL)**
• **MEYFROYT, Thomas, Meriam, Marcel**
**Veldhoven (NL)**
• **LUSITANI, Filippo**
**Veldhoven (NL)**

(74) Representative: **ASML Netherlands B.V.**
**Corporate Intellectual Property**
**P.O. Box 324**
**5500 AH Veldhoven (NL)**

(54) **METHOD OF OPTIMIZING A WEIGHTING FOR PARAMETER OF INTEREST DATA AND ASSOCIATED METROLOGY AND LITHOGRAPHIC APPARATUSES**

(57)    Disclosed is a method of optimizing a weighting for parameter of interest data. The method comprises obtaining parameter of interest data and reference data relating to a lithographic process, optimizing the weighting such that application of the weighting to said parameter of interest data improves performance of said lithographic process in terms of the reference parameter; and constraining the optimization so as to penalize changes in an average of reference data.

Fig. 8

**EP 4 498 163 A1**

**Description**

BACKGROUND

Field of the Invention

The present invention relates to methods and apparatus usable, for example, in the manufacture of devices by lithographic techniques, and to methods of manufacturing devices using lithographic techniques. The invention relates more particularly to metrology sensors and lithography apparatuses having such a metrology sensor.

Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In some metrology applications, such as in some scatterometers or alignment sensors, imperfections in metrology targets can result in a wavelength/polarization dependent variation in a measured value from that target. As such, correction and/or mitigation for this variation is sometimes effected by performing the same measurement using multiple different wavelengths and/or polarizations (or more generally, multiple different measurement conditions). It would be desirable to improve one or more aspects of measuring using multiple measurement conditions.

SUMMARY OF THE INVENTION

The invention in a first aspect provides a method of optimizing a weighting for parameter of interest data, the method comprising: obtaining parameter of interest data relating to a lithographic process comprising exposure of one or more structures on a substrate; obtaining reference data relating to a reference parameter which has a dependence on the said weighting; optimizing the weighting such that application of the weighting to said parameter of interest data improves performance of said lithographic process in terms of the reference parameter; and constraining said optimization so as to penalize changes in average reference data, said average reference data comprising an average of said reference data over a plurality of previous substrates and/or lots.

Also disclosed is a computer program, alignment sensor, metrology apparatus and a lithographic apparatus being operable to perform the method of the first aspect.

# EP 4 498 163 A1

The above and other aspects of the invention will be understood from a consideration of the examples described below.

BRIEF DESCRIPTION OF THE DRAWINGS

Embodiments of the invention will now be described, by way of example only, with reference to the accompanying drawings, in which:

Figure 1 depicts a schematic overview of lithographic apparatus;
Figure 2 depicts a schematic overview of a lithographic cell;
Figure 3 illustrates schematically measurement and exposure processes in the apparatus of Figure 1;
Figure 4 depicts a schematic representation of holistic lithography, representing a cooperation between three key technologies to optimize semiconductor manufacturing;
Figure 5 is a schematic illustration of an alignment sensor adaptable according to an embodiment of the invention;
Figure 6 schematically illustrates a scatterometry apparatus;
Figure 7 schematically illustrates a lot exposure schedule at four time periods illustrating a dynamic update method in accordance with an embodiment;
Figure 8(a) illustrates a color weighting recipe and resultant overlay for a prior art color weighting method;
Figure 8(b) illustrates a color weighting recipe and resultant overlay for a first example color weighting method with frequent updating;
Figure 8(c) illustrates a color weighting recipe and resultant overlay for a color weighting method with frequent updating according to an embodiment; and
Figure 9 illustrates schematically two feedback loops used in lithography to which concepts disclosed herein are applicable.

DETAILED DESCRIPTION OF EMBODIMENTS

Before describing embodiments of the invention in detail, it is instructive to present an example environment in which embodiments of the present invention may be implemented.

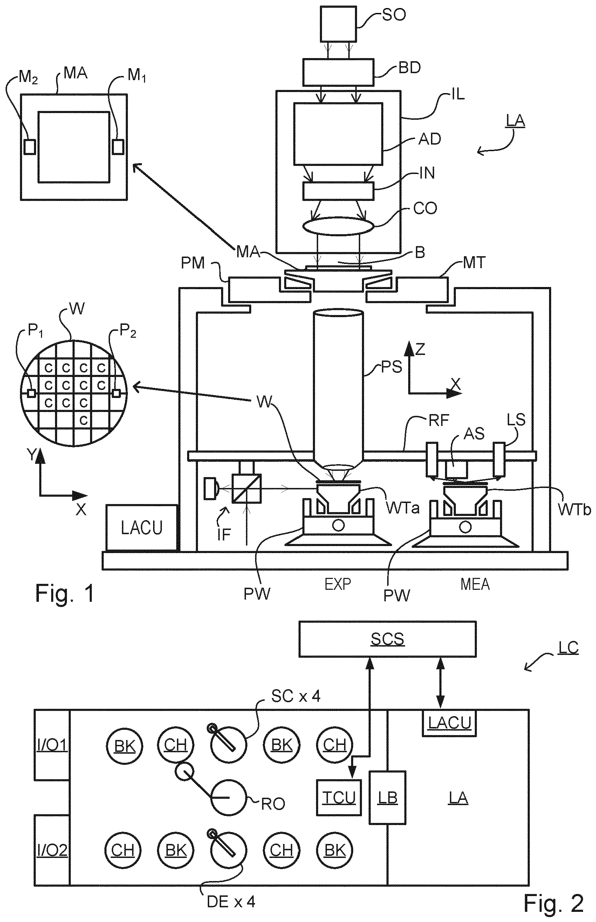

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA may be of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

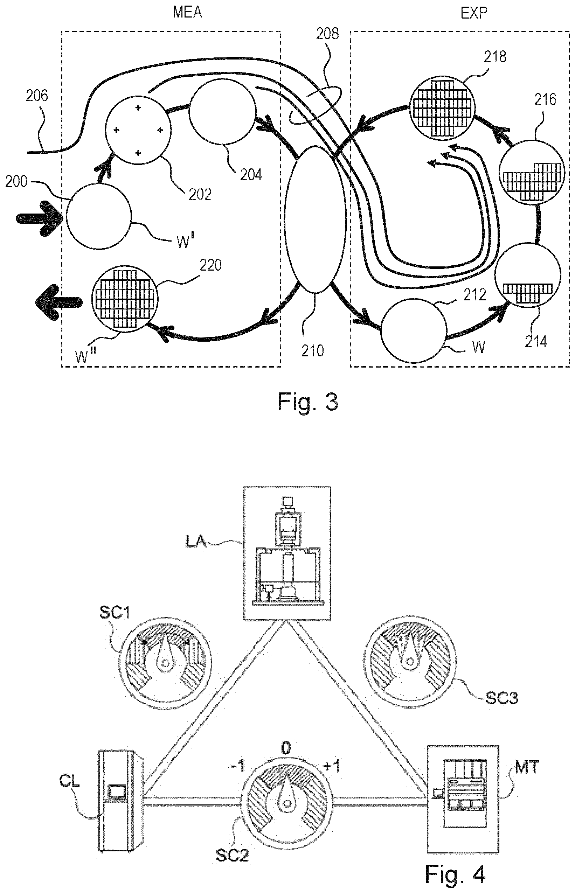

Figure 3 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks P1 etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

A mark, or alignment mark, may comprise a series of bars formed on or in a layer provided on the substrate or formed (directly) in the substrate. The bars may be regularly spaced and act as grating lines so that the mark can be regarded as a diffraction grating with a well-known spatial period (pitch). Depending on the orientation of these grating lines, a mark may be designed to allow measurement of a position along the X axis, or along the Y axis (which is oriented substantially perpendicular to the X axis). A mark comprising bars that are arranged at +45 degrees and/or -45 degrees with respect to both the X- and Y-axes allows for a combined X- and Y- measurement using techniques as described in US2009/195768A, which is incorporated by reference.

The alignment sensor scans each mark optically with a spot of radiation to obtain a periodically varying signal, such as a sine wave. The phase of this signal is analyzed, to determine the position of the mark and, hence, of the substrate relative to the alignment sensor, which, in turn, is fixated relative to a reference frame of a lithographic apparatus. So-called coarse and fine marks may be provided, related to different (coarse and fine) mark dimensions, so that the alignment sensor can distinguish between different cycles of the periodic signal, as well as the exact position (phase) within a cycle. Marks of different pitches may also be used for this purpose.

Measuring the position of the marks may also provide information on a deformation of the substrate on which the marks are provided, for example in the form of a wafer grid. Deformation of the substrate may occur by, for example, electrostatic clamping of the substrate to the substrate table and/or heating of the substrate when the substrate is exposed to radiation.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Figure 4. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 4 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 4 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 4 by the multiple arrows in the third scale SC3).

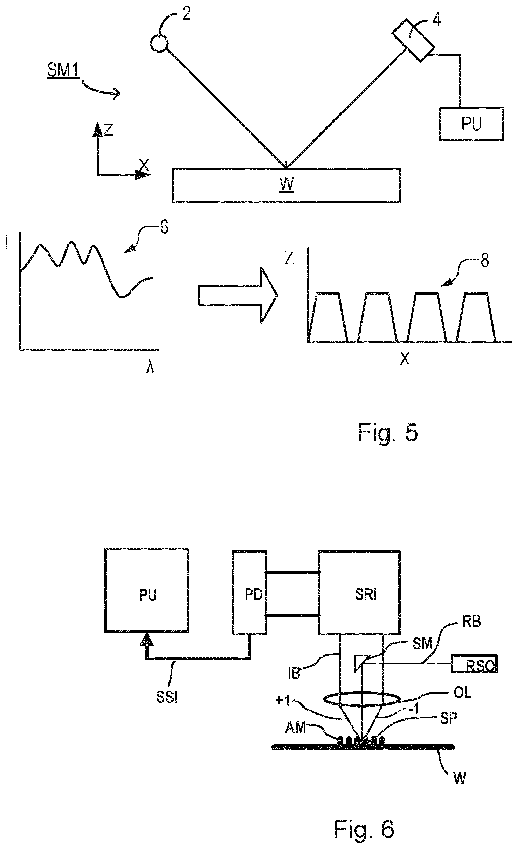

Figure 5 is a schematic block diagram of an embodiment of a known alignment sensor AS. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the mark AM is collimated (in this example via the objective lens OL) into an information-carrying beam IB. The term "diffracted" is intended to include complementary higher diffracted orders; e.g.,: +1 and -1 diffracted orders (labelled +1, -1) and optionally zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

SRI Intensity signals SSI are supplied to a processing unit PU. By a combination of optical processing in the self-referencing interferometer SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels are repeated at different wavelengths for increased accuracy and/or for robust detection of the mark irrespective of the materials from which the mark is made, and materials on and/or below which the mark is provided. Improvements in performing and processing such multiple wavelength measurements are disclosed below.

Figure 6 illustrates another type of metrology apparatus, a scatterometer. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 6. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

During the manufacturing of the ICs, it is of great importance that the process conditions for processing substrates using processing apparatus, such as the lithographic apparatus or etching station, remain stable such that properties of the features remain within certain control limits. Stability of the process is of particular importance for features of the functional parts of the IC, i.e., the product features. To guarantee stable processing, process control capabilities need to be in place. Process control involves monitoring of processing data and implementation of means for process correction, e.g. control the processing apparatus based on characteristics of the processing data. Process control may be based on periodic measurement by the metrology apparatus MT, often referred to as "Advanced Process Control" (further also referenced to as APC). More information on APC can be found in U.S. Patent Application Publication No. US20120008127, which is incorporated herein by reference. A typical APC implementation involves periodic measurements on metrology features on the substrates to monitor and correct drifts associated with one or more processing apparatus. The metrology features reflect the response to process variations of the product features.

In US20120008127, a lithographic apparatus is calibrated by reference to a primary reference substrate. Using an apparatus which need not be the same as the one being calibrated, there is obtained an apparatus-specific fingerprint of the primary reference substrate. Using the same set-up there is then obtained an apparatus-specific fingerprint of a secondary reference substrate. The apparatus-specific fingerprint of the primary reference substrate is subtracted from the apparatus-specific fingerprint of the secondary reference substrate to obtain and store an apparatus-independent fingerprint of the secondary reference substrate. The secondary reference substrate and stored apparatus-independent fingerprint are subsequently used together in place of the primary reference substrate as a reference for the calibration of the lithographic apparatus to be calibrated. Initial set-up for a cluster of lithographic tools can be performed with less use of the costly primary reference substrate, and with less interruption to normal production. The initial set up can be integrated with on-going monitoring and re -calibration of the apparatuses.

The term fingerprint may refer to a main (systematic) contributor ("latent factor") of a measured signal, and in particular a contributor connected to the performance impact on-wafer or to previous processing steps. Such a fingerprint can refer to substrate (grid) patterns (e.g. from alignment, leveling, overlay, focus, CD), field patterns (e.g., from intrafield alignment, leveling, overlay, focus, CD), substrate zone patterns (e.g., outermost radius of wafer measurements) or even patterns in scanner measurements related to wafer exposure (e.g., heating signature through- lot from reticle alignment measurements, temperature/pressure/servo profiles, etc.). Fingerprints may be comprised within a fingerprint collection, and may be encoded homogenously or heterogeneously therein.

As such, APC identifies correctable variation in a performance parameter or reference parameter such as overlay, and applies one set of corrections to a lot (batch) of wafers. In determining these corrections, corrections from previous lots are taken into account in order to avoid overcorrecting the noise in the measurements. For adequate smoothing of current corrections with previous ones, the history of corrections taken into account may match the context of the current lot. "Context" in this regard encompasses any parameters that identify variants arising within the same overall industrial process. The layer ID, layer type, product ID, product type, reticle ID and so forth are ah context parameters that may lead to different fingerprints in the finished performance. In addition to the individual scanners that may be used in a high-volume manufacturing (HVM) facility, the individual tools used for each of the coating, etching, and other steps involved in semiconductor manufacturing can also vary from lot to lot or wafer to wafer. Each of these tools can impose a particular error "fingerprint" Outside the field of semiconductor manufacturing, similar situations may arise in any industrial process.

To ensure accurate feedback control appropriate to the particular context, different lots (batches) of product units may be treated as separate "threads" in the APC algorithms. Context data can be used to assign each product unit to the correct thread. In the case of a manufacturing plant producing usually high volumes of only a few types of products by the same process steps, the number of different contexts may be relatively small, and the number of product units in each thread will be ample to allow smoothing of noise.

It is known that alignment marks and other metrology targets may be deformed by process variations (PV) substrate-to-substrate leading to on-product overlay errors. The term "mark" will be used herein to refer to any structure which may be measured in the methods disclosed herein; such structures may comprise alignment marks formed for the purpose of alignment, other metrology marks or targets formed for the purpose of metrology, and/or product structure which may be measured to obtain a metrology and/or position value.

In the context of wafer alignment, concepts such as OCW (Optimal Color Weighing) and the related OCIW (Optimal Color and Intensity Weighing) are in use or have been proposed to correct the mark position for such process variation (e.g., mark asymmetry, i.e., asymmetry in the alignment mark which results in a position error or offset). These concepts are described in more detail in the publications US2019/0094721, WO 2017032534A2, US2020/0272061A1 and US2020/0081356A1, all of which are incorporated herein by reference). Another concept comprises MCLR (Multi-Color Lowest Residuals) described in more detail in PCT publication WO2022184405A1 which is incorporated herein by reference.

The measured (e.g., alignment and/or phase) data will comprise (e.g., the sum of) a component due to process variation (e.g., mark asymmetry or mark deformation) and the desired wafer deformation component (i.e., desired position value or first parameter value). The process variation component shows a color-to-color variation (i.e., color dependence), while the desired wafer deformation component has no such dependency.

To address this, many alignment sensors are provided with the functionality to measure each alignment mark using multiple different measurement conditions (e.g., combinations of wavelength and polarization; note that "color" will be used throughout the description as shorthand for measurement condition, i.e., wavelength and polarization combination). In more basic techniques, an average of these per-color measurements and/or one or more better performing measurements are used to determine the aligned position. In OCW, a per-color weighting (i.e., a measurement recipe) for the measurement data (e.g., alignment data) may be determined, the weighting comprising (e.g., trained) positive and negative weights which minimize the impact of process variation on a parameter of interest such as overlay (or, for example, any other placement parameter such as edge placement error). The weighting should sum to unity to preserve the alignment signal.

OCIW is an improvement on OCW, where the metrology tool/alignment sensor has additional intensity channel functionality which can measure individually intensities of two complementary diffraction orders from each mark (e.g., the +1 and -1 orders, although pairs of higher orders are theoretically possible). In OCIW, an additional intensity weighting is determined for an intensity imbalance signal (e.g., based on an imbalance, such as a difference or ratio, of these +1 and -1 diffraction orders). In OCIW, the color weighting and intensity weighting may be trained together, again to minimize the impact of process variation on a parameter of interest such as overlay.

A main physics mechanism of OCW and OCIW is that the weighting creates (near) orthogonality to the process variation observed in the training data.

Another weighting technique may comprise a weighting based on "wafer quality" WQ or other mark reflectance metric (e.g., (normalized) reflectance of the mark). The term wafer quality or WQ will be used herein to refer to any such measure of mark reflectance (or signal amplitude) from the target. In WQ-weighting, only positive weights are used and these weights do not require training. However, these weights are determined per alignment mark, e.g., from the (normalized) reflectance of that alignment mark. The main physics mechanism of WQ-weighting is that weighting via target reflectance improves convergence of target asymmetry dispersion sum rule(s). Other metrics which may be used comprise a signal strength metric (e.g., intensity or amplitude metric) and/or measurement noise metric.

Similar color weighting principals and methods may be employed in metrology applications other than alignment (pre-exposure metrology). Such other metrology applications may comprise, for example post-exposure metrology such as overlay metrology (e.g., performed using a scatterometer, holographic microscope or otherwise). Mentions of optical color weighting (OCW) and measurement recipes can be understood to apply equally to those used for pre-exposure metrology such as alignment metrology and post-exposure metrology such as (e.g., scatterometer based) overlay metrology. In such an embodiment, a measurement recipe may be understood to describe a (e.g., color) weighting which weights respective different values of a parameter of interest such as position (e.g., aligned position deviation APD) or overlay of a structure using a different measurement setting such as color and/or polarization.

More generally, the concepts disclosed herein may apply to any metrology method for which a weighting or measurement recipe is applied to multiple repetitions of a measurement for which one or more measurement settings is varied, so as to address the issue of processing effects of the measured structure which result in measured value variation in a parameter of interest over the multiple repetitions. More generally still, the weighting may be any weighting on parameter of interest data which results in variation of a reference parameter as described in reference data.

A processing effect may be structure deformation (e.g., mark deformation or target deformation) such as an unwanted asymmetry in the structure (e.g., any asymmetry in an alignment mark or asymmetries other than overlay and bias in an overlay target). A measurement setting may be wavelength and/or polarization, or more generally any measurement setting which when varied results in a measured value variation in a parameter of interest for a structure.

Presently, the measurement recipe or color weighting is updated only infrequently for such color weighting techniques. This is to ensure stability of process control loops (e.g., APC loops), since an abrupt change to the measurement recipe will also require control loops to re-stabilize or even re-initialize, which in turn will have a negative overlay impact. However, if recipe updates are not performed with sufficient frequency, the measurement recipe will eventually be unable to correct for mark deformations that are introduced by process changes or drifts (e.g., the static parameter of interest fingerprint).

It is therefore proposed to provide an adaptive measurement recipe, which can correct for deformations caused by process changes and drifts, without (unduly) negatively impacting the control loop and ultimately overlay performance. The goal of such an adaptive alignment recipe, is to provide a measurement recipe that is the least sensitive to mark deformation at every moment in time, even when process changes occur.

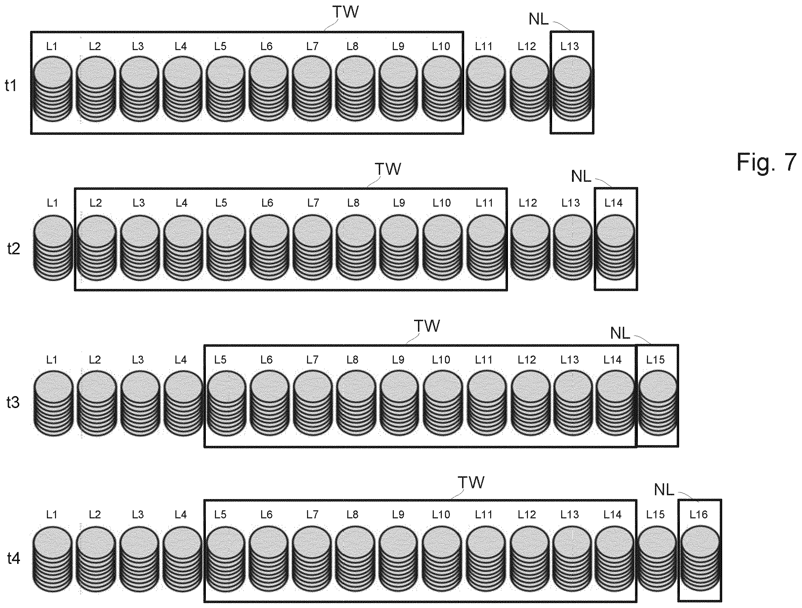

Figure 7 illustrates a proposed dynamic recipe update (e.g., for an OCW measurement recipe update) strategy where a measurement recipe for a future lot, e.g., the next lot to be exposed NL, is trained using reference data from a training window TW of previous lots. The reference data may relate to a reference parameter which has a dependence on the measurement recipe used, i.e., which can be used to assess performance of the measurement recipe. For example, in an alignment recipe determination, the reference data may comprise historic overlay data.

Figure 7 shows this dynamic recipe update at four different times t1-t4. In each case, the metrology recipe is updated every time new reference data becomes available. As such, at time t1, the training window covers lots L1-L10 (the training window may be any suitable size; 10 lots is purely an example), while lot L13 is to be exposed. This would suggest (historic) metrology data for lots L11 and L12 are not yet available. At time t2, lot L14 is to be exposed, with the training window moved on one lot. As such, a different measurement recipe (e.g., OCW recipe) may be used when exposing lot L11 as was used to expose lot L10 (e.g., to interpret/filter the alignment data prior to this exposure). At time t3, the metrology data for lots L12-L14 have become available and used to train the measurement recipe for exposure of lot L15, and also for lot L16 at time t4 (e.g., where no additional overlay data has become available between times t3 and t4).

However an unconstrained regular updating of the measurement recipe in this manner can actually impair overall manufacturing performance by disrupting the control loop(s) used to control the exposure, e.g., APC control loops.

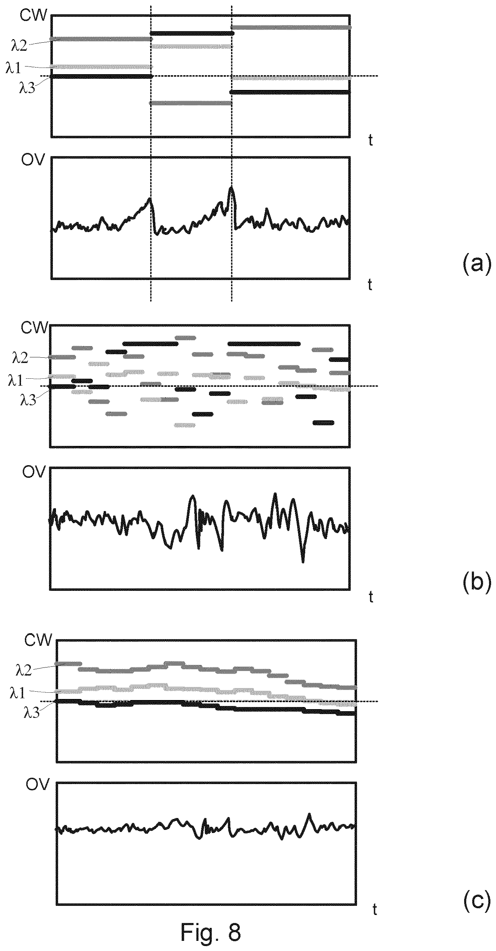

Figure 8(a) illustrates a typical present measurement recipe update strategy where the recipe is updated infrequently, e.g., when a better recipe is detected and/or when overlay error becomes too large. The top plot shows color weight values CW for each of three colors $\lambda 1$, $\lambda 2$, $\lambda 3$ against time t, and the bottom plot shows overlay error OV (i.e., peaks indicate worse overlay performance) against time t for the same time period. It can be seen that overlay drifts significantly in the time period immediately before each update. This overlay drift may be used to trigger the determination of a new measurement recipe, e.g., when overlay error passes a threshold. While the new recipe may indeed provide reduced wafer-to-wafer variation in overlay, it also generates a delta with respect to the previous recipe in terms of the average overlay fingerprint known by the established control (APC) loop. As the average fingerprint on subsequent lots will suddenly be different from the average expected by the established control (APC) loop, the control loop would make an incorrect correction resulting in worse overlay performance. To prevent this, the APC loop is reset, which involves stopping production and significant effort exposing and reworking several lots to establish a new control loop.

As such, performing recipe updates manually may require an operator needing to monitor overlay and/or alignment performance and to decide when a new recipe is needed. The frequency at which such performance is monitored can also have a large spread: e.g., days to weeks. If process changes occur during those intervals, this can have a negative impact on alignment and overlay performance; e.g., resulting in one or more exposed lots requiring re-work. If a new recipe is needed, then production may be stopped to reset the control loop, lots verified to see if any rework is required and production restarted.

Figure 8(b) comprises equivalent plots for an unconstrained regular updating of the measurement recipe. Here, the measurement recipe is changed abruptly every lot or so. However, every new recipe produces a different overlay fingerprint, and because these recipes differ significantly, so does each respective overlay fingerprint. Control loops such as APC rely on using an (e.g., moving) average of reference data (e.g., average overlay fingerprint) to remove systematic components of the reference data (e.g., systematic overlay fingerprints). As such, control loops such as APC become ineffective when the fingerprints change greatly at frequent time intervals. This will result in much worse overall performance due to deteriorated effectiveness of the APC loop. Moreover, since the updates are too frequent it is not possible or practical to reset the APC loop to restore overall performance.

To address this issue, it is proposed to perform regular updating of the measurement recipe (e.g., every time new metrology data becomes available for training the measurement recipe), but where the training is regularized to prevent the systematic fingerprint from changing too much too quickly. As such, the proposed method may comprise applying a regularization to the training to perform frequent recipe updates without disrupting the systematic overlay error (average fingerprint), such that the established control loop is still able to correct for any static fingerprint so that the frequent recipe changes do not cause additional overlay errors. The frequency of these updates can thus be as high as per lot allowing for tighter overlay control which is robust against process changes, thereby resulting in less production variability.

The proposed regularization may penalize changes in the average reference data. The average reference data may comprise average (e.g., historic) metrology data, such as average fingerprint data. Fingerprint data may comprise spatial distributions of a parameter of interest over a substrate area, e.g., the whole substrate or a portion thereof such as a die, field or zone. In the specific example illustrated below, where the proposed method is used in the context of determining a color recipe for alignment measurement, e.g., in an OCW or OCIW method, the parameter of interest may be overlay error or other placement error (e.g., edge placement error EPE). However, this is only one specific implementation and a generalized description and other applications of the concept will also be described.

Figure 8(c) illustrates the effect of implementing a color weighting strategy as proposed herein. It can be seen that the measurement recipe may be changed frequently (e.g., at least every five lots, at least every four lots, at least every three lots, at least every two lots, every lot and/or when new metrology data becomes available), but is constrained to change only slowly over time. This means that the optimization method is allowed to regularly find an alternative recipe which improves wafer-to-wafer and/or lot-to-lot variation of the parameter of interest while also ensuring the average fingerprint remains stable, which is required for APC control. This means that the control loop is still able to correct for a static component of the reference data (fingerprint data).

The proposed method comprising applying a regularization to the optimization cost function used in training the metrology recipe, the regularization constraining the difference between the average fingerprint as weighted by a previous measurement recipe and the new measurement recipe. The previous measurement recipe may be understood as the recipe applied on the immediately preceding lot, or as the recipe applied to the lots in the training window. The constraint may apply a regularization penalty to this difference.

The training cost function typically used determines a weighting or measurement recipe (e.g., color weighting w) as that which minimizes a (e.g., squared) magnitude of the difference between the weighted parameter of interest data (e.g., APD data), as weighted by the measurement recipe, and reference data (e.g., overlay data). In an embodiment, the parameter of interest data and reference data may each have had a static component removed such that each comprises a substrate varying component or wafer-to-wafer component of that data, e.g., such that it describes a wafer-to-wafer component of the parameter of interest data and reference data respectively. This is because any systematic or constant errors may normally be handled and corrected by another control loop such as the APC feedback loop, at least in an alignment context. In other embodiments and contexts, the full parameter of interest data and reference data may be used.

As such, a known training function may take the form:

$$w = \arg\min_{w} \|X \cdot w - y\|^2$$

where X is the (e.g., wafer-to-wafer variation of the) parameter of interest data and $y$ is the (wafer-to-wafer variation of the) reference data.

The proposed regularized cost function may take the form:

$$w = \arg\min_{w} \left( \|X \cdot w - y\|^2 + \lambda \|X_{AVG} \cdot (w - w_{prev})\|^2 \right)$$

where $X_{AVG}$ is the average parameter of interest data (e.g., over all or some previous lots), $w_{prev}$ is the old measurement recipe or weighting and $\lambda$ is a tunable regularization parameter that enables tuning of the regularization strength. In an alternative formulation, a proposed regularized cost function may take the form:

$$w = \arg\min_{w} \left( \|X \cdot w - y\|^2 + \lambda \|X_{AVG} \cdot w - x_{AVG,active}\|^2 \right)$$

Here, the quantity $x_{AVG,active}$ represents a suitable average fingerprint of the active corrections (e.g., alignment corrections) that were applied to the wafers in the training data (e.g. with their active recipe already applied, where the active recipe here may be different on each lot or wafer). This formulation may be more practical as it does not require bookkeeping of the old measurement recipe(s) $w_{prev}$.

The average parameter of interest data (e.g., average APD data) is typically ignored in present optimizations such as these. Using this average parameter of interest data to regularize the training enables optimization of reference parameter performance (e.g., good wafer-to-wafer overlay performance) while maintaining a sufficiently stable average parameter of interest data such that the average parameter of interest data remains similar to the parameter of interest data which would have been observed with the old recipe $w_{prev}$.

Intuitively, it may be thought that constraining the recipe change directly (e.g., such that the regularization term takes the form $\lambda\|w - w_{prev}\|^2$), rather than the average parameter of interest data, might also provide similar benefits. However, this tends to over-constrain the optimization and hinder performance, as it severely limits the freedom for recipe change. By contrast, the regularization proposed herein provides freedom for the recipe to jump/change as long as it does not overly affect the average parameter of interest data. In addition, in directly constraining the recipe change, it is unclear how to handle the situation when a color transitions from zero weight to non-zero weight or *vice versa*.

The methods described above have largely been described in the context of OC(I)W in alignment, such that the parameter of interest data comprises alignment data or position data and the reference data comprises overlay data (e.g., as measured using a scatterometer, although other metrology methods may be used). However, the method may also be used in the training for the overlay metrology itself (e.g., scatterometer based overlay metrology). In such an embodiment, the parameter of interest data may comprise overlay data as measured using a scatterometer and the reference data may comprise reference overlay data using a reference tool such as an electron microscope (e.g., a scanning electron microscope SEM/e-beam tool or transmission electron microscope TEM). It can be appreciate that such a reference tool is more accurate than a scatterometer, but is typically too slow for (e.g., in-line) metrology within a control loop. Alternatively to using a different tool, the reference overlay data in this context may also be measured using a scatterometer, but using more expensive metrology techniques, e.g., which would be too slow for inline metrology.

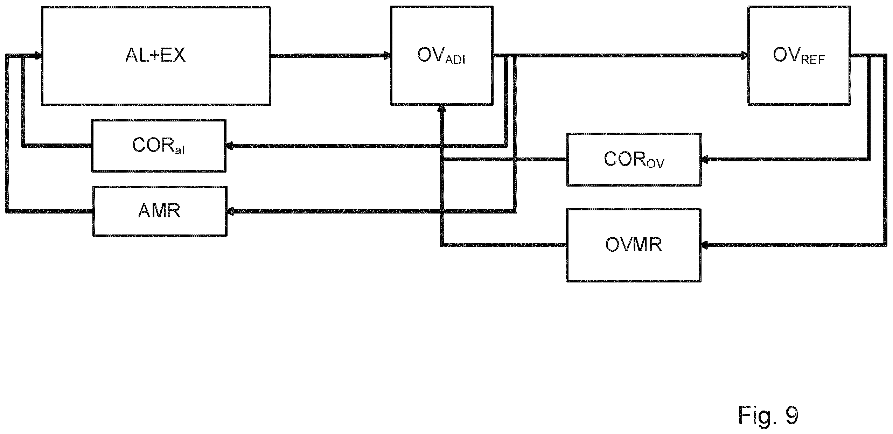

Figure 9 illustrates how both of these regularized optimizations may be used in combination. The Figure shows an alignment and exposure step (e.g., as performed on a lithographic apparatus) followed by an ADI (after development inspection, i.e., before etch and in resist) overlay metrology step $OV_{ADI}$. The overlay metrology data may be used to determine alignment corrections $COR_{al}$ in a first feedback loop (e.g., APC loop). In addition to this, the overlay data and its average may be used to determine a new alignment measurement recipe AMR in a regularized optimization as has been described. Similarly, the overlay metrology step $OV_{ADI}$ may be referenced against reference overlay data as measured using in a reference overlay step $OV_{REF}$, e.g., using an SEM. The reference overlay data may be used to determine overlay corrections $COR_{ov}$ in a second feedback loop. In addition to this, the reference overlay data and its average may be used to determine a new overlay measurement recipe OVMR in a regularized optimization as has been described.

It can be appreciated that the concepts herein can be further extended beyond color weight training in metrology applications. The concepts disclosed herein may be used to update and/or optimize model parameters or basis functions of a model e.g., an alignment model used to model the alignment data. Alternatively or in addition the concepts disclosed herein may be used to update and/or optimize sampling schemes used to describe parameter of interest data such as alignment data or overlay data.

For example, the weighting or measurement recipe to be optimized in such embodiments may comprise a particular selection of model parameters or basis functions of a model used to represent the parameter of interest data, such that reference parameter performance or overlay performance is dependent upon which model parameters or basis functions are applied to the optimization. As before, the parameter of interest data may comprise alignment data and the (average) reference data may comprise (average) overlay data (e.g., in all cases with the systematic component removed). The cost function may otherwise be the same as already described.

The weighting or measurement recipe update method may be employed in a dynamic sampling scheme for e.g., overlay metrology or alignment metrology. In such an embodiment, the weighting may comprise a sampling scheme describing a particular subset of measurement locations of possible measurement locations, such that this sampling scheme is optimized. In such an embodiment, for example, the parameter of interest data may comprise alignment data and the reference data may comprise overlay data, or the parameter of interest data may comprise overlay data (e.g., as measured using a scatterometer) and the (average) reference data may comprise (average) reference overlay data (e.g., as measured using an electron microscope). Once again, the systematic component may be removed from all datasets prior to optimization.

It can be further appreciated that the proposed regularization method may be used to regularize any optimization of a weighting applied to parameter of interest data so as to improve performance in terms of a reference parameter.

It can be appreciated that any of the average reference data described herein may be averaged per lithographic apparatus, per chuck and/or per thread.

The following clauses describe further aspects and/or embodiments of the concepts disclosed herein:

1. A method of optimizing a weighting for parameter of interest data, the method comprising:

obtaining parameter of interest data relating to a lithographic process comprising exposure of one or more structures on a substrate;
obtaining reference data relating to a reference parameter which has a dependence on the said weighting;
optimizing the weighting such that application of the weighting to said parameter of interest data improves performance of said lithographic process in terms of the reference parameter; and
constraining said optimization so as to penalize changes in average reference data, said average reference data comprising an average of said reference data over a plurality of previous substrates and/or lots.

2. A method according to clause 1, wherein said constraining step comprises applying a regularization to said optimization which penalizes a difference in said average reference data as weighted with the optimized weighting and said average reference data as weighted with a previous weighting.

3. A method according to clause 2, wherein said previous weighting comprises a weighting applied to lots used in a previous optimization or training of the weighting.

4. A method according to clause 2 or 3, wherein said previous weighting comprises a weighting comprising or derived from an average of active corrections which were applied to lots used in a previous optimization or training of the weighting.

5. A method according to clause 2, wherein said previous weighting comprises a weighting applied in a previous lot.

6. A method according to clause 5, wherein said previous lot comprises the immediately preceding lot exposed in said lithographic process.

7. A method according to any preceding clause, wherein said optimization comprises optimizing a cost function comprising a regularization term applying said regularization, wherein said optimizing the cost function comprises optimizing said weighting so as to minimize a difference between the parameter of interest data as weighted by said weighting and said reference data as constrained by said regularization term.

8. A method according to any preceding clause, wherein said regularization comprises a regularization parameter enabling the strength of the regularization to be tuned.

9. A method according to any preceding clause, comprising performing said optimization each time new reference data becomes available.

10. A method according to any preceding clause, comprising performing said optimization at scheduled intervals in time or based on a number of processed lots.

11. A method according to any preceding clause, comprising performing said optimization at least after every five lot of substrates.

12. A method according to any preceding clause, comprising performing said optimization at least after every three lot of substrates.

13. A method according to any preceding clause, wherein said parameter of interest data comprises alignment data or overlay data.

14. A method according to any preceding clause, wherein said reference data comprises reference overlay data.

15. A method according to any preceding clause, wherein said weighting comprises a per-measurement setting weighting for measurement settings of measurement radiation used to measure said one or more structures to obtain said parameter of interest data.

16. A method according to clause 15, wherein said measurement settings include one or more of: different wavelengths, different polarizations and/or different combinations of wavelength and/or polarization.

17. A method according to any of clauses 1 to 14, wherein said weighting describes a selection of model parameters or basis functions of a model used to represent the parameter of interest data.

18. A method according to any of clauses 1 to 14, wherein the weighting comprises a sampling scheme describing a particular subset of measurement locations of possible measurement locations used to measure the parameter of interest data.

19. A method according to any preceding clause, wherein said parameter of interest data and reference data each comprise a substrate varying component, having had a static component removed.

20. A method according to any preceding clause, comprising applying said weighting to said parameter of interest data to obtain weighted parameter of interest data

21. A method according to clause 20, comprising performing a measurement of said one or more structures on the substrate in accordance with said weighted parameter of interest data.

22. A method according to clause 20 or 21, comprising performing said lithographic process in accordance with said weighted parameter of interest data.

23. A computer program comprising program instructions operable to perform the method of any of clauses 1 to 20, when run on a suitable apparatus.

24. A non-transient computer program carrier comprising the computer program of clause 23.

25. A processing system comprising a processor and a storage device comprising the computer program of clause 23.

26. A metrology device operable to perform the method of any of clauses 1 to 21.

27. A metrology device according to clause 26, wherein said metrology device comprises a scatterometer or holographic microscope.

28. A metrology device according to clause 26, wherein said metrology device comprises an alignment sensor.

29. A lithographic apparatus comprising:

    a patterning device support for supporting a patterning device;
    a substrate support for supporting a substrate; and
    the alignment sensor of clause 28.

30. A lithographic apparatus comprising:

    a patterning device support for supporting a patterning device;
    a substrate support for supporting a substrate; and
    wherein said lithographic apparatus is operable to perform any of the methods of clauses 1 to 22.

The term "optimizing" and "optimization" as used herein refers to or means adjusting a lithographic apparatus, a device manufacturing process, etc. such that results and/or processes of lithography or device manufacturing have more desirable characteristics, such as higher accuracy of projection of a design layout on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

## Claims

1. A method of optimizing a weighting for parameter of interest data, the method comprising:

   obtaining parameter of interest data relating to a lithographic process comprising exposure of one or more structures on a substrate;
   obtaining reference data relating to a reference parameter which has a dependence on the said weighting;
   optimizing the weighting such that application of the weighting to said parameter of interest data improves performance of said lithographic process in terms of the reference parameter; and
   constraining said optimization so as to penalize changes in average reference data, said average reference data comprising an average of said reference data over a plurality of previous substrates and/or lots.

2. A method as claimed in claim 1, wherein said constraining step comprises applying a regularization to said optimization which penalizes a difference in said average reference data as weighted with the optimized weighting and said average reference data as weighted with a previous weighting.

3. A method as claimed in claim 2, wherein said previous weighting comprises one of:

   a weighting applied in a previous lot or immediately previous lot;
   a weighting applied to lots used in a previous optimization or training of the weighting; or
   a weighting comprising or derived from an average of active corrections which were applied to lots used in a previous optimization or training of the weighting.

4. A method as claimed in claim 2 or 3, wherein said optimization comprises optimizing a cost function comprising a regularization term applying said regularization, wherein said optimizing the cost function comprises optimizing said weighting so as to minimize a difference between the parameter of interest data as weighted by said weighting and said reference data as constrained by said regularization term.

5. A method as claimed in claim 2, 3 or 4, wherein said regularization comprises a regularization parameter enabling the strength of the regularization to be tuned.

**6.** A method as claimed in any preceding claim, wherein said parameter of interest data comprises alignment data or overlay data.

**7.** A method as claimed in any preceding claim, wherein said reference data comprises reference overlay data.

**8.** A method as claimed in any preceding claim, wherein said weighting comprises a per-measurement setting weighting for measurement settings of measurement radiation used to measure said one or more structures to obtain said parameter of interest data
wherein said measurement settings include one or more of: different wavelengths, different polarizations and/or different combinations of wavelength and/or polarization.

**9.** A method as claimed in any of claims 1 to 7, wherein said weighting describes a selection of model parameters or basis functions of a model used to represent the parameter of interest data.

**10.** A method as claimed in any of claims 1 to 7, wherein the weighting comprises a sampling scheme describing a particular subset of measurement locations of possible measurement locations used to measure the parameter of interest data.

**11.** A method as claimed in any preceding claim, comprising applying said weighting to said parameter of interest data to obtain weighted parameter of interest data

**12.** A method as claimed in claim 11, comprising performing said lithographic process in accordance with said weighted parameter of interest data.

**13.** A computer program comprising program instructions operable to perform the method of any of claims 1 to 12, when run on a suitable apparatus.

**14.** A processing system comprising a processor and a storage device comprising the computer program of claim 13.

**15.** A metrology device operable to perform the method of any of claims 1 to 12.

Fig. 1

Fig. 2

MEA

EXP

Fig. 3

Fig. 4

Fig. 5

Fig. 6

EP 4 498 163 A1

TW NL

t1 | L1 L2 L3 L4 L5 L6 L7 L8 L9 L10 | L11 L12 | L13

TW NL

t2 | L1 | L2 L3 L4 L5 L6 L7 L8 L9 L10 L11 | L12 L13 | L14

TW NL

t3 | L1 L2 L3 L4 | L5 L6 L7 L8 L9 L10 L11 L12 L13 L14 | L15

TW NL

t4 | L1 L2 L3 L4 | L5 L6 L7 L8 L9 L10 L11 L12 L13 L14 | L15 | L16

Fig. 7

Fig. 8

Fig. 9

Europäisches
Patentamt

European
Patent Office

Office européen
des brevets

# EUROPEAN SEARCH REPORT

**Application Number**

EP 23 18 8234

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 4 053 636 A1 (ASML NETHERLANDS BV [NL]) 7 September 2022 (2022-09-07) * abstract * * figure 4 * * paragraphs [0001], [0044] - [0056] * | 1-15 | INV. G03F7/20 |
| A | "Robust alignment recipe method", RESEARCH DISCLOSURE, KENNETH MASON PUBLICATIONS, HAMPSHIRE, UK, GB , vol. 710, no. 3 1 April 2023 (2023-04-01), XP007151305, ISSN: 0374-4353 Retrieved from the Internet: URL:https://www.researchdisclosure.com/database/RD710003 [retrieved on 2023-04-24] * the whole document * | 1-15 | |
| A | WO 2022/106182 A1 (ASML NETHERLANDS BV [NL]) 27 May 2022 (2022-05-27) * abstract * * figure 8 * * paragraphs [0002], [0053] - [0075] * | 1-15 | TECHNICAL FIELDS SEARCHED (IPC) G03F |
| A | US 2022/114438 A1 (PANDEV STILIAN IVANOV [US] ET AL) 14 April 2022 (2022-04-14) * abstract * * figure 1 * * paragraphs [0002], [0017] - [0019], [0058] - [0060], [0083], [0097] * | 1-15 | |

The present search report has been drawn up for all claims

| Place of search | Date of completion of the search | Examiner |
|---|---|---|
| Munich | 9 January 2024 | Andersen, Ole |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 498 163 A1**

## ANNEX TO THE EUROPEAN SEARCH REPORT
## ON EUROPEAN PATENT APPLICATION NO.

EP 23 18 8234

09-01-2024

| Patent document cited in search report | | | Publication date | Patent family member(s) | | | Publication date |
|---|---|---|---|---|---|---|---|
| EP 4053636 | A1 | | 07-09-2022 | CN | 116964530 | A | 27-10-2023 |
| | | | | EP | 4053636 | A1 | 07-09-2022 |
| | | | | WO | 2022184405 | A1 | 09-09-2022 |
| WO 2022106182 | A1 | | 27-05-2022 | CN | 116648675 | A | 25-08-2023 |
| | | | | JP | 2023549656 | A | 29-11-2023 |
| | | | | KR | 20230104889 | A | 11-07-2023 |
| | | | | TW | 202225821 | A | 01-07-2022 |
| | | | | US | 2023418168 | A1 | 28-12-2023 |
| | | | | WO | 2022106182 | A1 | 27-05-2022 |
| US 2022114438 | A1 | | 14-04-2022 | CN | 116324393 | A | 23-06-2023 |
| | | | | JP | 2023544761 | A | 25-10-2023 |
| | | | | KR | 20230082014 | A | 08-06-2023 |
| | | | | TW | 202232092 | A | 16-08-2022 |
| | | | | US | 2022114438 | A1 | 14-04-2022 |
| | | | | WO | 2022076173 | A1 | 14-04-2022 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 2006066855 A1
- WO 2009078708 A
- WO 2009106279 A
- US 20110027704 A
- US 20110043791 A
- US 2011102753 A1
- US 20120044470 A
- US 20120123581 A
- US 20130258310 A
- US 20130271740 A
- WO 2013178422 A1
- US 20100328655 A
- US 20110249244 A
- US 20110026032 A
- EP 1628164 A
- US 451599
- US 11708678 B
- US 12256780 B

- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 6961116 B
- US 2015261097 A1
- US 2009195768 A
- US 20120008127 A
- US 20190094721 A
- WO 2017032534 A2
- US 20200272061 A1
- US 20200081356 A1
- WO 2022184405 A1